# EUROPEAN PATENT SPECIFICATION

(11) **EP 1 675 160 B1**
(45) Date of publication and mention of the grant of the patent: **04.06.2008**
(21) Application number: 05027533.8
(22) Date of filing: 15.12.2005
(51) Int. Cl.: H01L 21/00

(54) **Electrostatic chuck with built-in heater**
Elektrostatische Klemme mit einer eingebauten Heizung
Borne électrostatique avec chauffage intégré

(30) Priority: 22.12.2004 JP 2004371593
(43) Date of publication of application: 28.06.2006
(73) Proprietor: Shin-Etsu Chemical Co., Ltd., Tokyo (JP)
(72) Inventor: Yamamura, Waichi, Annaka-shi Gunma-ken (JP)
(74) Representative: Müller, Thomas

(56) References cited:
- EP-A- 1 132 936
- WO-A-02/01611
- US-A- 5 668 524
- US-B1- 6 538 872

## Description

### BACKGROUND OF THE INVENTION

### 1. Field of the Invention

The present invention relates to an electrostatic chuck with a built-in heater, which is used in a film forming apparatus in the manufacture of semiconductor devices, and, more particularly, relates to a disk-shaped electrostatic chucking head with a built-in heater, with which rapid temperature elevation is possible and the entire area of the heater can be heated to a uniform temperature by temperature elevation.

### 2. Description of the Related Art

With plasma etching apparatuses or film-forming apparatuses such as those that make use of plasma CVD, reduced-pressure CVD, optical CVD, PVD, and so on, which are used mainly for forming a fine circuit wiring on the surface of a semiconductor wafer in the course of manufacturing semiconductor devices, the semiconductor wafer is held on the surface of an electrostatic chuck with a built-in heater, inside a reaction chamber. To maintain in-plane uniformity of etching or film formation on a semiconductor wafer, it is important that the semiconductor wafer placed on the disk-shaped heater be uniformly heated.

In the prior art, with this type of a disk heater, an electrostatic chuck with a built-in heater was used in which the wafer placement surface was the top of a disk-shaped insulating substrate made of a ceramic such as alumina or aluminum nitride, inside of which an electrostatic chuck electrode was provided on the side on which the wafer was placed, and a belt-shaped heating resistor composed of a metal with a high melting point, such as nichrome or tungsten, was embedded on the other side. The pattern of this belt-shaped heating resistor was usually formed as substantially concentric circles or in a spiral pattern (WO 01/04945 A1).

European Patent Application EP 1 132 936 A1 describes a fixing unit, said fixing unit being comprised of several electrostatic chucks. A chuck consists of a conductive layer, said layer serving as an electrode. The chuck is a single layer component, said electrode being integrated therein. A first topmost surface of the chuck comprises a groove. Said groove has the function of introducing a gas between the surface of a substrate and the surface of the chuck, in order to improve thermal contact there between.

United States Patent 5,668,524 teaches grooves on the surface of an electrostatic chuck. The purpose of these grooves is to enhance adsorbing capability to silicon wafers.

With an electrostatic chuck, an electrostatic chucking force is generated between the workpiece to be chucked and the electrostatic chuck electrode, which causes the workpiece to be attracted to the electrostatic chuck. Electrostatic chucking force is classified into two types: Coulomb force and what is known as the Johnsen-Rahbek force.

Both of these forces are inversely proportional to the square of the distance between the electrostatic chuck electrode and the wafer (the workpiece under working). Accordingly, the distance between the chucked item and the electrostatic chuck surface is an important factor in controlling the chucking force, and, if there is a difference in the chucking force resulting from the position of the workpiece being chucked, this is believed to be correlated to broadening in the temperature distribution of the semiconductor wafer surface.

With a conventional electrostatic chuck with a built-in heater such as this, the surface is usually finished to be smooth enough in an effort to ensure temperature uniformity.

In the step of forming a fine circuit on a wafer, the surface temperature of an electrostatic chuck with a built-in heater is kept between 350 and 500 °C, and, after passing through a gate valve and entering a reaction chamber, the wafer is placed on a lift pin or the like provided in an up-and-down slidable fashion through the electrostatic chuck with a built-in heater, and the wafer is slowly lowered to the surface of the electrostatic chuck.

When a specific voltage is applied to the electrode of the electrostatic chuck, the wafer is chucked in place by electrostatic force, and an electric current flowing through a heating resistor, which raises the temperature.

A wafer that enters the reaction chamber through the gate valve usually has moisture or gas adsorbed on its surface. If the wafer is rapidly heated, any gas or moisture adsorbed on the back side of the wafer is also rapidly heated and desorbed from the wafer, accumulates between the electrostatic chuck and the wafer, and may adversely affect wafer adhesion. This can result in large local differences in the temperature distribution on the wafer.

Therefore, a wafer that has entered the reaction chamber through the gate valve cannot be heated right away, and it is necessary to take the time to thoroughly degas the wafer first.

Also, during start-up of the wafer processing apparatus, there is a possibility that moisture or gas is adsorbed on the electrostatic chuck with a built-in heater itself, so an operator usually takes the time to preheat and degas a wafer processing apparatus at the start-up, meaning that warm-up time is required at the start of operation, which results in a poor operating efficiency.

### SUMMARY OF THE INVENTION

In light of the above problems, it is an object of the present invention to provide an electrostatic chuck with a built-in heater, with which a device can begin operating quickly at the wafer mounting surface, and a uniform temperature distribution can be quickly formed over the wafer.

According to the present invention, an electrostatic chuck with a built-in heater is provided, which comprises: a first insulating topmost layer having an outer surface which exhibits a function of electrostatic chucking of a workpiece. The chuck is characterised in that a second insulating topmost layer is provided, said second insulating topmost layer having an outer surface opposite to the first insulating topmost layer to serve as a heating means, each of the outer surfaces of the first and second insulating topmost layers being provided with a plurality of gas-escape grooves each communicating with the outer peripheral edge of the insulating topmost layers.

The electrostatic chuck with a built-in heater of the present invention is characterized in that gas-escape grooves communicating with the outer peripheral edge are provided to one or both of the sides. The electrostatic chuck function of the electrostatic chuck with a built-in heater of the present invention is constituted by stacking an insulating first layer, an electroconductively patterned second layer, and an insulating third layer by CVD successively on a thermally conductive substrate.

Advantageously, the insulating topmost layers each have a thickness in the range from 60 to 200 µm.

Preferably, each of the insulating topmost layers is formed on a heat-conductive base body with intervention of an insulating underlayer on the base body and an electroconductive layer on the insulating underlayer.

It is preferable if the surface shape of the insulating third layer smoothly drops off from the flat surface toward the gas-escape grooves. Advantageously, the gas-escape groove has a cross section smoothly and gradually dropping off from the flat surface area of the insulating topmost layer to the bottom of the gas-escape groove.

It is preferred, if the gas-escape grooves have a width of 1 to 3 mm. Advantageously, they have a depth of 0.03 to 0.2 mm. Preferably, the spacing between grooves is from 5 to 15 mm.

While it is a conventional practice in order to prevent inhibition of direct contacting of the wafer to the electrostatic chuck that, in the starting-up of the wafer processing apparatus or in the setting of a wafer therein, a loss of time is unavoidable for degassing the gas or moisture adsorbed thereon depending on the gaseous atmosphere in the preceding steps or during pause of running by means of thermal expansion, gasification and desorption under heating to increase the temperature, it is now possible according to the present invention to quickly start the temperature elevation of the wafer without any time loss for degassing so as to effect uniform transfer of heat from the electrostatic chuck to the wafer and to ensure uniformity of the temperature distribution on the surface of the wafer mounted on the electrostatic chuck.

### BRIEF DESCRIPTION OF THE DRAWINGS

FIG. 1 is a diagram illustrating an embodiment of the groove pattern formed on the surface of the electrostatic chuck with a built-in heater of the present invention;
FIG. 2 is a diagram illustrating another embodiment of the groove pattern formed on the surface of the electrostatic chuck with a built-in heater of the present invention;
FIG. 3 is a diagram schematically illustrating a cross section of the groove shape formed on the surface of the electrostatic chuck with a built-in heater of the present invention;
FIG. 4 is a detailed diagram of the shape near the edge of a groove; and
FIG. 5 is a simplified diagram of a semiconductor manufacturing apparatus pertaining to the present invention.

### DESCRIPTION OF THE PREFERRED EMBODIMENTS

As a result of various research into generally increasing the speed and efficiency of the work entailed by processing semiconductor wafers with the use of an electrostatic chuck, and into a method for increasing the uniformity of the temperature distribution on a wafer placement surface, the inventors have arrived at the present invention upon discovering that, if small grooves that communicate with an outer peripheral edge are formed on the face on which the wafer is placed and on the face in contact with the apparatus frame or a heat sink on the heating resistor side, and if the pressure resulting from heating and removing any gas or moisture that has been adsorbed on the wafer or the electrostatic chuck is released through the grooves in these portions, then the heating operation can be commenced right away, without taking any special time for degassing, and the wafer can be heated more uniformly.

Specifically, the electrostatic chuck with a built-in heater of the present invention is characterized in that grooves provided on the surface are made to communicate with the outer peripheral edge, and, as a result, any pressure increase resulting from degassing and generated between the wafer and the electrostatic chuck face, or between the electrostatic chuck and the apparatus frame or a heat sink, will be released through the grooves formed in the insulating layer that is the outermost layer.

The electrostatic chuck with a built-in heater of the present invention will now be described through reference to the drawings.

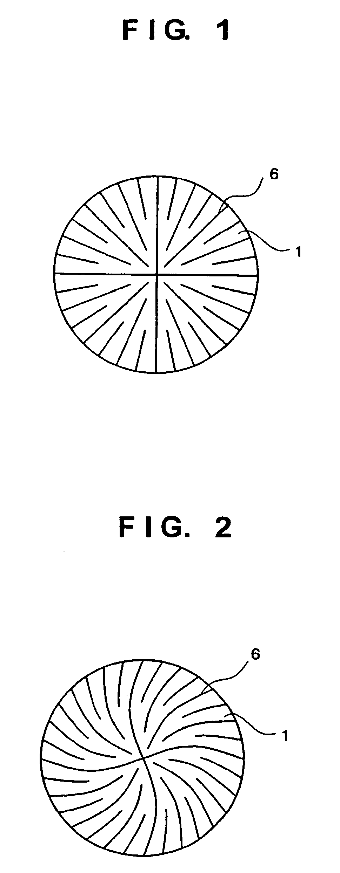

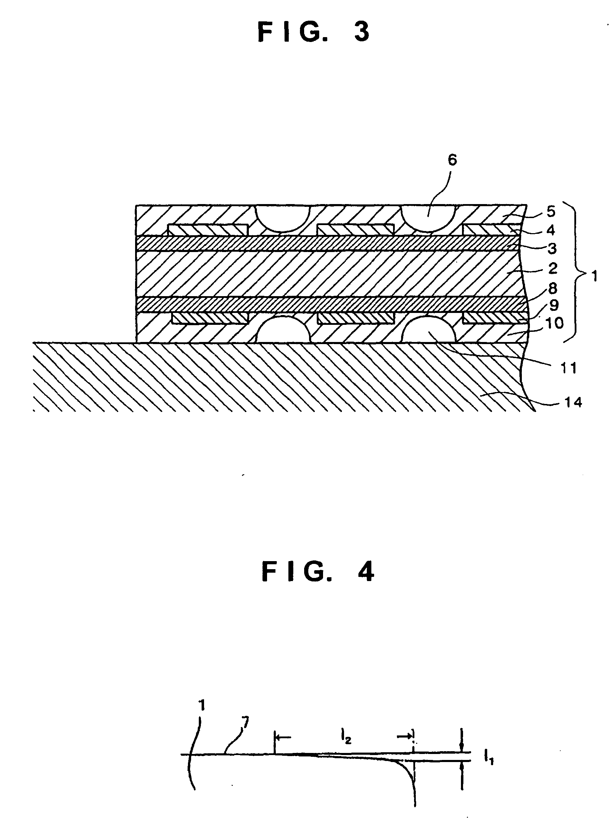

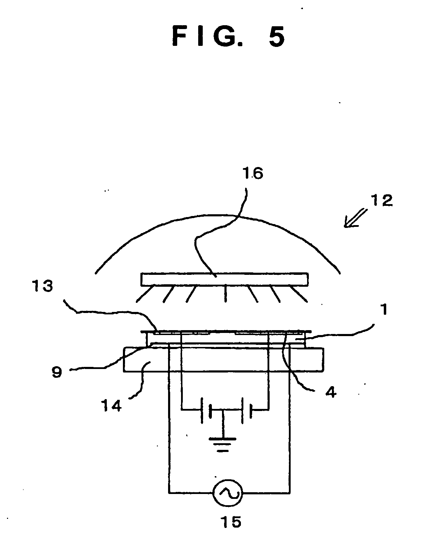

FIG. 1 is a diagram illustrating an embodiment of the groove pattern formed on the surface of the electrostatic chuck with a built-in heater of the present invention. FIG. 2 is a diagram illustrating another embodiment of the groove pattern formed on the surface of the electrostatic chuck with a built-in heater of the present invention. FIG. 3 is a diagram schematically illustrating a cross section of the groove shape formed on the surface of the electrostatic chuck with a built-in heater of the present invention. FIG. 4 is an enlarged cross sectional diagram of the shape near the shoulder of the groove. FIG. 5 is a simplified diagram of a semiconductor manufacturing apparatus pertaining to the present invention.

The electrostatic chuck with a built-in heater of the present invention has on its surface grooves having the cross sectional shape shown in FIGS. 3 and 4.

In FIG. 3, the electrostatic chuck with a built-in heater 1 mounted on an apparatus frame 14 has an insulating first underlayer 3, an electroconductively patterned second layer (electrostatic chuck electrode) 4, and an insulating topmost layer 5, formed in this order on one side of a heat-conductive substrate 2 (preferably made of a material such as graphite). This results in an electrostatic chuck function. Gas-escape grooves 6, preferably with a width of 1 to 3 mm and a depth of 0.03 to 0.2 mm, are formed in the insulating topmost layer 5.

As shown in FIG. 4, the surface 7 of the insulating third layer 5 is formed in such a fashion that there is a slow drop-off, in a maximum depth of from 2 to 10 µm (I₁) over a range of about 0.5 to 1 mm (I₂) toward the gas-escape grooves 6. This drop-off culminates in a curve of 0.5 to 3 mm in radius of curvature. Providing this slow drop-off minimizes the decrease in affixing force on the semiconductor wafer at a position near the gas-escape grooves 6.

The pattern of the gas-escape grooves 6 can be set as appropriate, but examples are shown in FIGS. 1 and 2. In FIG. 1, a suitable number (four in FIG. 1) of straight gas-escape grooves 6 are formed radially communicating from the center of the surface 7 of the insulating third layer 5 to the outer peripheral edge thereof, and shorter, straight gas escape grooves intervene between these longer grooves so that the spacing between the gas-escape grooves 6 is between 5 and 15 mm.

In FIG. 2, the gas-escape grooves are each curved in a spiral form as contrasted to the straight grooves in FIG. 1.

The effect of providing the gas-escape grooves is that even if the gas or moisture adsorbed on the semiconductor wafer is desorbed or expands upon being heated, it can be expelled to the outside without remaining at the interface between the semiconductor wafer and the electrostatic chuck and raising the pressure, so when this electrostatic chuck 1 is assembled into a semiconductor wafer processing apparatus, and semiconductor wafers are subjected to processing such as film formation or etching, heating to a specified temperature can be commenced right away, without waiting for a warm-up period for degassing in the setting of the semiconductor wafer in place.

Returning to FIG. 3, the heater function side of the electrostatic chuck with a built-in heater 1 is the opposite side to the electrostatic chucking function side, and consists of a (heater function side) insulating first layer 8, a (heater function side) heating second layer 9 (preferably made from nichrome, tungsten, or the like), and a (heater function side) insulating third layer 10, formed in this order. (Heater function side) gas-escape grooves 11 that are the same as those provided to the insulating third layer 5 are preferably formed on the surface of the (heater function side) insulating third layer 10. The effect of providing the (heater function side) gas-escape grooves 11 to the electrostatic chuck with a built-in heater 1 is that, when a semiconductor wafer processing apparatus is started up after making a pause, it can begin working more quickly, without loss of time for the degassing of the semiconductor wafer processing apparatus and so on.

As shown in FIG. 5, the electrostatic chuck or electrostatic chuck with a built-in heater of the present invention is attached to an apparatus frame 14 or heat sink of a semiconductor wafer processing apparatus 12. 13 is a semiconductor wafer (the item to be processed), 15 is a power supply, and 16 is a target, which will vary with the processing.

With the electrostatic chuck with a built-in heater attached to the semiconductor wafer processing apparatus, for example, an AC power supply is under thyristor control so that the heater temperature is measured with a thermocouple (not shown), and the semiconductor process is kept constant by a PID controller (not shown) at about 350 to 500 °C, over a range of relatively high temperatures.

A wafer placed on the surface of this heated electrostatic chuck may release the gas having been adsorbed in the preceding step. However, the chucking timing of the electrostatic chuck with a built-in heater of the present invention is such that the heating up to the specified temperature can be commenced without first waiting for the back of the wafer to be degassed, this chucking can be performed at the same time as the wafer comes into contact with the electrostatic chuck face, and the wafer is heated simultaneously with the chucking operation, but any gas or moisture desorbed or generated by this is expelled to the outside through the grooves provided to the chuck surface.

Accordingly, the gas resulting from degassing never accumulates between the chuck surface and the back surface of the wafer, there is no decrease in the chucking force due to the pressure increase which would otherwise result from degassing, and an entire eight-inch silicon wafer, for instance, can be uniformly heated at a temperature variation not exceeding 1%.

As discussed above in detail, with the present invention, the wafer placement surface is the chucking face of the disk-shaped electrostatic chuck with a built-in heater, and fine grooves that communicate between the center and the outer periphery are formed on the surface of the insulating layer of the chuck, the result of which is that it is possible to suppress the increase in pressure caused by heating in a closed space between the back of the wafer and the chuck face, and uniform chucking performance is obtained without any variance in the gap between the wafer and the electrostatic chuck, so a wafer placed on the placement surface can be uniformly heated.

As a result, a uniform thickness can be achieved during film formation on a wafer surface, and excellent precision can be attained in etching, enabling production of semiconductor devices of high quality.

By using the electrostatic chuck of the invention, as discussed above, chucking can be performed more rapidly contributing to the improvement in the productivity.

The surface to which the gas-escape grooves are provided is not limited to the chucking surface of the electrostatic chuck but the heater-side surface can also be provided with similar grooves 11. This design of the chuck with a built-in heater gives a further advantage in the starting up of the apparatus or after replacement of the electrostatic chuck with a new one so that the gases or moisture occurring therein can be discharged more reliably.

With the present invention, with a semiconductor device manufacturing process or manufacturing apparatus, there is no need to wait for degassing of adsorbed gases or moisture when a wafer (the workpiece to be processed) is replaced or when the apparatus is started up after making a pause, so the apparatus can be quickly heated or cooled to the desired temperature, and as a result, a stable temperature distribution is obtained in a short time, and productivity is enhanced, which contributes greatly to the industry of manufacturing semiconductor devices.

The present invention provides an electrostatic chuck with a built-in heater, with which the apparatus can start operation rapidly at the wafer chucking surface, and a uniform temperature distribution can be rapidly established over the wafer. Gas-escape grooves which communicate with the outer periphery are provided to one or both sides of the electrostatic chuck. The chucking function of the electrostatic chuck with a built-in heater of the present invention is exhibited by stacking an insulating underlayer, an electroconductive layer, and an insulating topmost layer by the CVD method on a heat-conductive base body. It is preferable that the gas-escape groove has a cross section smoothly dropping off from the flat surface area of the insulating topmost layer to the bottom of the groove, and that the gas-escape groove has a width of 1 to 3 mm and a depth of 0.03 to 0.2 mm with a spacing between grooves of 5 to 15 mm.

## Claims

1. An electrostatic chuck with a built-in heater (1) which comprises a first insulating topmost layer (5) having an outer surface (7) which exhibits a function of electrostatic chucking of a workpiece, a second insulating topmost layer (10) is provided, said second insulating topmost layer (10) having an outer surface opposite to the first insulating topmost layer (5) to serve as a heating means, **characterised in that** each of the outer surfaces of the first and second insulating topmost layers (5; 10) being provided with a plurality of gas-escape grooves (6; 11) each communicating with the outer peripheral edge of the insulating topmost layers (5; 10).

2. The electrostatic chuck with a built-in heater (1) as claimed in claim 1 in which the insulating topmost layers (5; 10) each have a thickness in the range from 60 to 200 µm.

3. The electrostatic chuck with a built-in heater (1) as claimed in claim 1 or 2 in which each of the insulating topmost layers (5; 10) is formed on a heat-conductive base body (2) with intervention of an insulating underlayer (3; 8) on the base body (2) and an electroconductive layer (4; 9) on the insulating underlayer (3; 8).

4. The electrostatic chuck with a built-in heater (1) as claimed in anyone of claims 1 to 3 in which the gas-escape groove (6; 11) has a cross section smoothly and gradually dropping off from the flat surface area of the insulating topmost layer (5; 10) to the bottom of the gas-escape groove (6; 11).

5. The electrostatic chuck with a built-in heater (1) as claimed in anyone of claims 1 to 4 in which each of the gas-escape grooves (6; 11) has a width of 1 to 3 mm.

6. The electrostatic chuck with a built-in heater (1) as claimed in anyone of claims 1 to 5 in which each of the gas-escape grooves (6; 11) has a depth of 0.03 to 0.2 mm.

7. The electrostatic chuck with a built-in heater (1) as claimed in anyone of claims 1 to 6 in which the spacing between adjacent gas-escape grooves (6; 11) is 5 to 15 mm.

## Patentansprüche

1. Elektrostatischer Halter mit einer eingebauten Heizeinrichtung (1), der aufweist eine erste isolierende oberste Schicht (5) mit einer äußeren Oberfläche (7), die eine Funktion des elektrostatischen Haltens eines Werkstücks ausübt, eine zweite isolierende oberste Schicht (10), wobei die zweite isolierende oberste Schicht (10) eine äußere Oberfläche gegenüber der ersten isolierenden obersten Schicht (5) aufweist, um als ein Heizmittel zu dienen, **dadurch gekennzeichnet, dass** jeder der äußeren Oberflächen der ersten und zweiten isolierenden obersten Schichten (5; 10) eine Vielzahl von Gas-Entweichungsrinnen (6; 11) aufweist, die jeweils mit der äußeren peripheren Kante der isolierenden obersten Schichten (5; 10) kommunizieren.

2. Elektrostatischer Halter mit eingebauter Heizeinrichtung (1) gemäß Patentanspruch 1, bei dem die isolierenden obersten Schichten (5; 10) jeweils eine Dicke im Bereich von 60 bis 200 µm aufweisen.

3. Elektrostatischer Halter mit eingebauter Heizeinrichtung (1) gemäß einem der Ansprüche 1 oder 2, bei dem jede der isolierenden obersten Schichten (5; 10) auf einem wärmeleitenden Grundkörper (2) ausgebildet ist, mit Intervention einer isolierenden Unterschicht (3; 8) auf dem Grundkörper (2) und einer elektrisch leitenden Schicht (4; 9) auf der isolierenden Unterschicht (3; 8).

4. Elektrostatischer Halter mit eingebauter Heizeinrichtung (1) gemäß einem der Ansprüche 1 bis 3, bei dem die Gas-Entweichungsrinne (6; 11) einen Querschnitt aufweist, der glatt und graduell von dem flachen Oberflächenbereich der isolierenden obersten Schicht (5; 10) zum Boden der Gas-Entweichungsrinne (6; 11) abfällt.

5. Elektrostatischer Halter mit eingebauter Heizeinrichtung (1) gemäß einem der Ansprüche 1 bis 4, bei dem jede der Gas-Entweichungsrinnen (6; 11) eine Breite von 1 bis 3 mm aufweist.

6. Elektrostatischer Halter mit eingebauter Heizeinrichtung (1) gemäß einem der Ansprüche 1 bis 5, bei dem jede der Gas-Entweichungsrinnen (6; 11) eine Tiefe von 0.03 bis 0.2 mm aufweist.

7. Elektrostatischer Halter mit eingebauter Heizeinrichtung (1) gemäß einem der Ansprüche 1 bis 6, bei dem der Abstand zwischen benachbarten Gas-Entweichungsrinnen (6; 11) 5 bis 15 mm beträgt.

## Revendications

1. Mandrin électrostatique avec un dispositif de chauffage intégré (1) qui comprend une première couche supérieure isolante (5) comportant une surface externe (7) qui présente une fonction de blocage électrostatique d'un pièce d'oeuvre, une seconde couche supérieure isolante (10) est formée, ladite seconde couche supérieure isolante (10) comportant une surface externe opposée à la première couche supérieure isolante (5) pour servir de moyen de chauffage, **caractérisé en ce que** chacune des surfaces externes des première et seconde couches supérieures isolantes (5 ; 10) comporte une pluralité de rainures d'échappement de gaz (6 ; 11) chacune communiquant avec le bord périphérique externe des couches supérieures isolantes (5 ; 10).

2. Mandrin électrostatique avec un dispositif de chauffage intégré (1) selon la revendication 1, dans lequel les couches supérieures isolantes (5 ; 10) présentent chacune une épaisseur dans la plage de 60 à 200 µm.

3. Mandrin électrostatique avec un dispositif de chauffage intégré (1) selon la revendication 1 ou 2, dans lequel chacune des couches supérieures isolantes (5 ; 10) est formée sur un corps de base thermiquement conducteur (2) avec intervention d'une sous-couche isolante (3 ; 8) sur le corps de base (2) et d'une couche électro-conductrice (4 ; 9) sur la sous-couche isolante (3 ; 8).

4. Mandrin électrostatique avec un dispositif de chauffage intégré (1) selon l'une quelconque des revendications 1 à 3, dans lequel la rainure d'échappement de gaz (6 ; 11) présente une section transversale régulière s'étendant progressivement à partir de la zone superficielle plate de la couche supérieure isolante (5 ; 10) vers le fond de la rainure d'échappement de gaz (6 ; 11).

5. Mandrin électrostatique avec un dispositif de chauffage intégré (1) selon l'une quelconque des revendications 1 à 4, dans lequel chacune des rainures d'échappement de gaz (6 ; 11) présente une largueur de 1 à 3 mm.

6. Mandrin électrostatique avec un dispositif de chauffage intégré (1) selon l'une quelconque des revendications 1 à 5, dans lequel chacune des rainures d'échappement de gaz (6 ; 11) présente une profondeur de 0,03 à 0,2 mm.

7. Mandrin électrostatique avec un dispositif de chauffage intégré (1) selon l'une quelconque des revendications 1 à 6, dans lequel l'espacement entre des rainures d'échappement de gaz adjacentes (6 ; 11) est de 5 à 15 mm.
